# FASCICULE DE BREVET EUROPEEN

(11) **EP 1 154 489 B1**
(45) Date de publication et mention de la délivrance du brevet: **23.02.2011**
(21) Numéro de dépôt: 01401111.8
(22) Date de dépôt: 27.04.2001
(51) Int. Cl.: H01L 27/146, H01L 31/0352, H01L 31/0232

(54) **Détecteur optique bi-spectral**
Bispektraler optischer Detektor
Bispectral optical detector

(30) Priorité: 12.05.2000 FR 0006072
(43) Date de publication de la demande: 14.11.2001
(73) Titulaire: Thales, 75008 Paris (FR)
(72) Inventeur: Bois, Philippe, 94117 Arcueil Cedex (FR); Costard, Eric, 94117 Arcueil Cedex (FR); Audier, Marcel-Francis, 94117 Arcueil Cedex (FR); Herniou, Eric, 94117 Arcueil Cedex (FR)
(74) Mandataire: Chaverneff, Vladimir

(56) Documents cités:
- EP-A- 0 849 798
- EP-A- 0 849 799
- EP-A- 0 999 600
- US-A- 5 552 603
- CHEN E ET AL: "A NOVEL DEVICE FOR DETECTING THE POLARIZATION DIRECTION OF LINEAR POLARIZED LIGHT USING INTEGRATED SUBWAVELENGTH GRATINGS AND PHOTODETECTORS" IEEE PHOTONICS TECHNOLOGY LETTERS,US,IEEE INC. NEW YORK, vol. 9, no. 9, 1 septembre 1997 (1997-09-01), pages 1259-1261, XP000721228 ISSN: 1041-1135
- SCHABLITSKY S J ET AL: "A wavelength and polarization detector using monolithically integrated subwavelength MSM photodetectors" 1997 55TH ANNUAL DEVICE RESEARCH CONFERENCE DIGEST (CAT. NO.97TH8279), 1997 55TH ANNUAL DEVICE RESEARCH CONFERENCE DIGEST, FORT COLLINS, CO, USA, 23-25 JUNE 1997, pages 168-169, XP002160770 1997, New York, NY, USA, IEEE, USA ISBN: 0-7803-3911-8
- TIDROW ET AL: "Grating coupled multicolor well infrared photodetectors" APPLIED PHYSICS LETTERS, vol. 67, no. 13, 25 septembre 1995 (1995-09-25), pages 1800-1802, XP000526485 Woodbury, NY, US

## Description

L'invention concerne un détecteur optique bi-fonctionnel permettant de détecter deux longueurs d'ondes et cela tout en éliminant le bruit de fond.

L'objet de la présente invention est de décrire l'architecture permettant de combiner deux fonctionnalités spécifiques et déjà démontrées des détecteurs à puits quantiques : la possibilité de réaliser des dispositifs bispectraux (brevet français n° 2 756 667) et la possibilité de réaliser des détecteurs intégrant dans la couche active la fonction de soustraction de la composante continue c'est-à-dire le courant d'obscurité d'origine thermique et le courant optique de scène (brevet français n° 2 756 666). Chacune de ces deux fonctions nécessite un double empilement de puits quantiques et une connectique à 3 étages. L'invention permet de conserver ce nombre d'empilements et d'étages de connectiques, tout en permettant la lecture en mode soustractif et selon trois gabarits spectraux : λ₁, λ₂ et λ₁ + λ₂.

Le document EP 0 999 600 décrit une structure matricielle intégrée comportant des éléments détecteurs à base de puits quantiques ayant chacun son réseau de diffraction. Tidrow et al divulgue dans l'article "Grating coupled multicolor quantum well infrared photodetectors", Applied Physics Letters Vol.67 no. 13, Sept. 1995 US, un détecteur optique bi-fonctionnel avec des éléments détecteurs actifs a base de puits quantiques permettant de détecter deux longueurs d'ondes, et dans lequel chaque élément détecteur ayant un réseau de diffraction permettant de coupler la lumière incidente d'un longueur d'onde spécifique dans le respectif élément détecteur.

L'invention concerne donc un détecteur optique bi-fonctionnel comportant :
- un premier élément détecteur actif à photoconducteur capable de détecter une première gamme et une deuxième gammes de longueurs d'ondes, et auquel est associé un premier réseau de diffraction permettant de coupler, dans ce premier élément détecteur, la lumière de la première gamme de longueurs d'ondes pour permettre au premier élément détecteur actif à photoconducteur de détecter la lumière de la première gamme de longueurs ;
- un deuxième élément détecteur actif à photoconducteur capable de détecter une première gamme et une deuxième gamme de longueurs d'ondes, et auquel est associé un deuxième réseau de diffraction permettant de coupler, dans ce deuxième élément détecteur, la lumière de la deuxième gamme de longueurs d'ondes, pour permettre au deuxième élément détecteur actif à photoconducteur de détecter la lumière de la deuxième gamme de longueurs d'ondes.

- le premier élément détecteur est associé à un troisième élément détecteur séparés par une couche de contact commune; le deuxième élément détecteur étant également associé un quatrième élément détecteur séparé de celui-ci par la couche de contact;
- le troisième élément détecteur et le quatrième élément détecteur formant également un même détecteur;
- les quatre éléments détecteurs étant photoconducteurs sous l'effet des mêmes gammes de longueurs d'ondes.

L'invention concerne aussi un procédé de réalisation de tels détecteurs tel comme définit dans la revendication 9.

Les différents objets et caractéristiques de l'invention apparaîtront à la lecture de la description et des figures annexées :
- la figure 1, une structure de puits quantique permettant de détecter deux gammes de longueurs d'ondes ;
- la figure 2, le gabarit spectral de la structure à puits quantique de la figure 1 ;
- la figure 3, un exemple de structure d'un détecteur selon l'invention ;
- la figure 4, l'absorption et la réponse induite par les réseaux de la structure de la figure 3 ;
- la figure 5, une vue de dessus de la structure de la figure 3 ;
- la figure 6, une matrice de détecteurs selon l'invention ;
- la figure 7, un tableau de modes de fonctionnement.

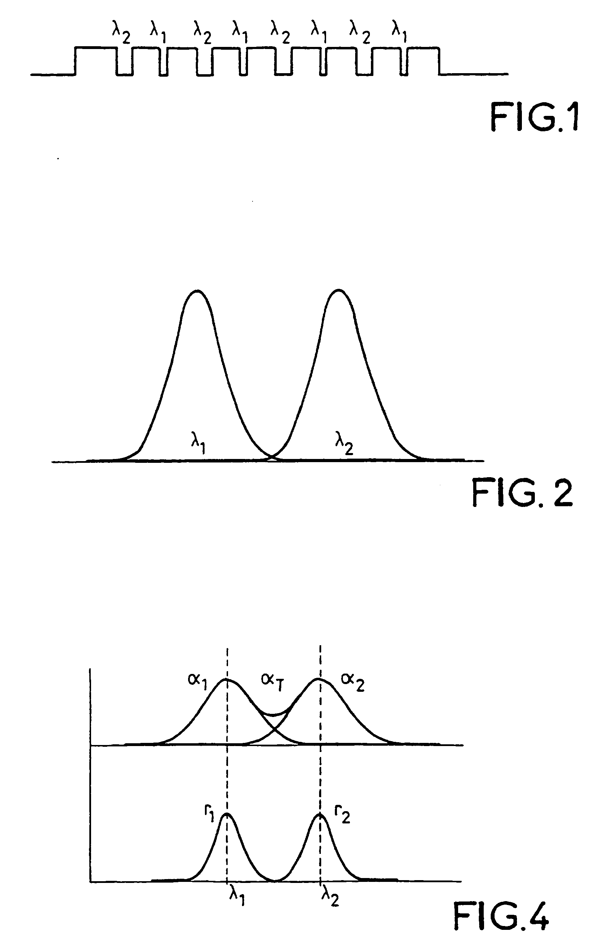

L'architecture proposée est identique à celle d'un composant soustractif tel que décrit dans le brevet français n° 2 756 666, mais ici, chacune des deux couches actives est constituée d'une alternance de deux motifs de puits quantiques (figure 1), dessinés pour l'absorption et la détection à deux longueurs d'ondes λ₁ et λ₂ avec deux gabarits spectraux Δλ₁ et Δλ₂. Le gabarit spectral résultant est la somme des deux gabarits spectraux Δλ₁ et Δλ₂ (figure 2). La réalisation d'une telle structure de détection à puits quantiques a été publiée par S. Bandara et al., APL 72, p.2427 (1998).

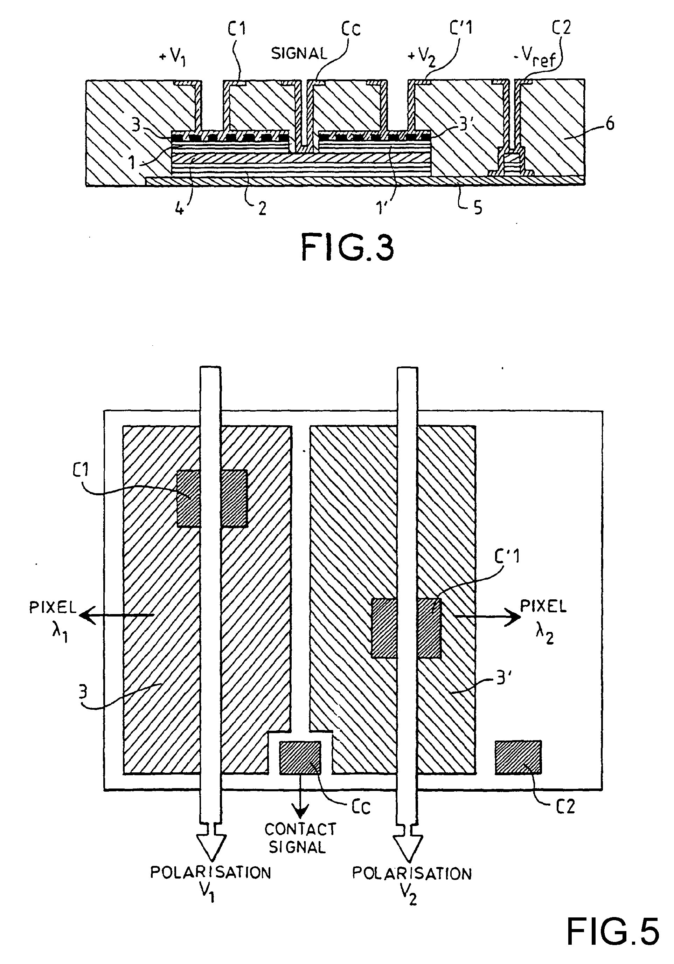

La réponse spectrale d'un détecteur à puits quantiques est la convolution de l'absorption spectrale du détecteur et de l'efficacité spectrale induite par la résonance géométrique du réseau de diffraction utilisé pour le couplage optique du rayonnement incident. Ainsi, un réseau de diffraction résonant autour de λ₁ (respectivement λ₂) couplé à la structure quantique décrite précédemment induira une réponse centrée autour de λ₁ (respectivement λ₂) (figure 4). Le principe de l'invention est de séparer le pixel principal de taille a x a en deux sous-pixels de taille a x a/2, chacun de ces sous-pixels étant une structure soustractive classique, mais comportant deux réseaux de couplage différents (figures 3 et 5).

La polarisation de l'étage inférieur Vref commune à l'ensemble des pixels de la matrice reste commune aux deux types de sous-pixels. Par contre, la polarisation de l'étage supérieur qui est également commune à l'ensemble des pixels de la matrice doit ici être dédoublée, chaque sous-réseau de sous-pixels étant polarisé de manière commune. La connectique de l'étage supérieur est ici assurée par deux lignes de polarisation V₁ et V₂ par pixel au lieu d'une seule pour un pixel soustractif standard (figure 5).

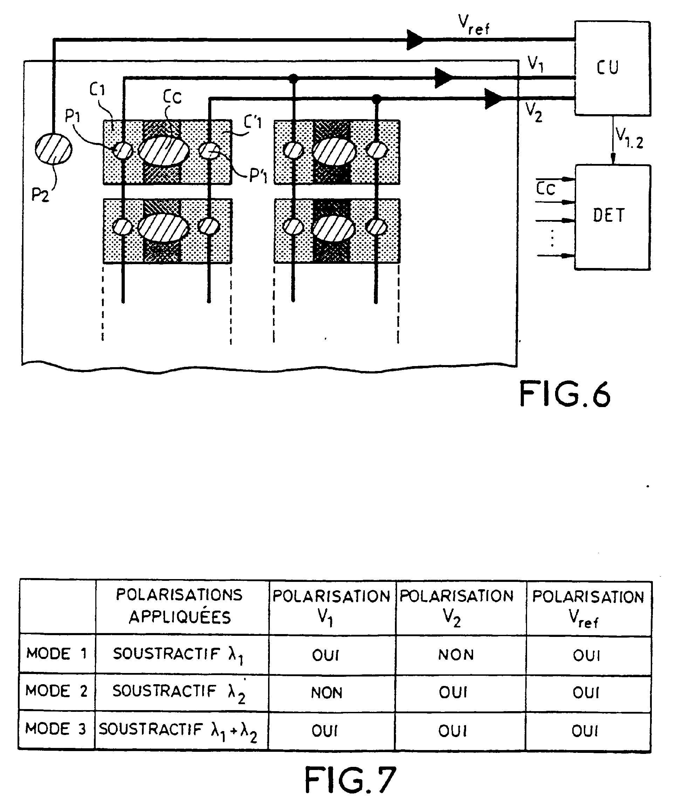

Le dispositif peut alors être utilisé en trois modes soustractifs correspondant aux trois gabarits spectraux Δλ₁, Δλ₂ et Δλ₁+ Δλ₂ différents selon les tensions que l'on applique à chacune des électrodes supérieures (figure 6).

Selon un mode de réalisation préférentiel de l'invention, un détecteur optique est réalisé sur un substrat transparent à travers lequel la lumière incidente arrive sur le détecteur. Un tel détecteur optique comporte donc, sur le substrat, une structure telle que représentée à la figure 3. Cette structure comporte sur une face du substrat une première couche de contact ohmique 5, cette couche de contact ohmique étant transparente. Sur cette couche de contact ohmique est situé un empilement de couches 2 constituant un empilement de puits quantiques capable de détecter deux gammes de longueurs d'ondes λ₁ et λ₁. Sur cet empilement de couches se trouve une deuxième couche de contact ohmique transparente 4. Sur la deuxième couche de contact ohmique se trouvent deux empilements de couches identiques ou quasi-identiques 1, 1' constituant chacun un empilement alterné de puits quantiques capables de détecter des gammes de longueurs d'ondes λ₁ et λ₂ et enfin sur chacun de ces empilements de couches se trouvent des réseaux de diffraction 3 et 3' de structures différentes telles que ces réseaux permettent chacun de coupler dans l'empilement de couches (1, 1' sur lequel il est réalisé) soit la lumière à la longueur d'onde λ₁ soit la lumière à la longueur d'onde λ₂. Comme représenté en figure 3, l'ensemble est encapsulé dans une couche d'isolant 6 et des moyens de connexion traversent cette couche d'isolant pour atteindre les réseaux de diffraction et réaliser des moyens de connexion C1 et C'1 permettant d'appliquer des tensions +V1 et +V2 respectivement aux réseaux de diffraction 3 et 3'. Egalement, au moins un moyen de connexion traverse la couche d'isolant et atteint la deuxième couche de contact ohmique 4 de façon à réaliser le contact commun Cc permettant la lecture du signal de photoconduction. Et enfin un moyen de connexion C2 est réalisé sur la première couche de contact ohmique 5 de façon à pouvoir appliquer à l'ensemble de la structure la tension -Vref.

La figure 5 représente en vue du dessus un couple d'éléments détecteurs tel que celui de la figure 3. Dans l'exemple de réalisation de la figure 3, l'empilement de couches de puits quantiques 2 constitue en fait deux détecteurs élémentaires, chacun d'eux étant associé à un élément détecteur 1 ou 1' en vue d'éliminer le bruit de fond tel que cela a été expliqué dans le brevet français n° 2 756 666.

Les empilements de couches de puits quantiques 1, 1', 2 sont actifs ou photoconducteurs aux mêmes gammes de longueurs d'ondes λ₁ et λ₂. Les empilements de couches 1 et 1' sont conçus pour être plus absorbants aux longueurs d'ondes λ₁ et λ₂ que l'empilement de couche 2. L'empilement de couche 2 est de préférence conçu pour n'être quasiment pas absorbant. Cela peut être prévu par des épaisseurs différentes des empilements de couches ou par dopage plus important des couches de puits quantiques des empilements les plus absorbants.

Le détecteur étant éclairé par un rayonnement incident sur la couche de contact ohmique 5, l'empilement de couche 2 reçoit en premier le rayonnement. Celui-ci traverse donc l'empilement de couche 2 puis les empilements de couches 1 et 1' et ils sont couplés par les réseaux de diffraction 3 et 3', selon la longueur d'onde reçue (λ₁ et λ₂) dans les empilements de couches 1 et 1'.

Si le réseau de diffraction 3 est prévu pour coupler la lumière à la longueur d'onde λ₁, la lumière à la longueur d'onde λ₁ sera diffractée vers l'empilement de couche 1 et sera absorbé ou quasiment absorbé par cet empilement de couches. De même, si le réseau de diffraction 3' est prévu pour diffracter la lumière à la longueur d'onde λ₂, la lumière sera absorbée ou quasiment absorbée par l'empilement de couche 1'.

La figure 6 représente une réalisation matricielle d'un détecteur matriciel selon l'invention. Sur cette figure, on a représenté à titre d'exemple quatre détecteurs optiques tels que décrits précédemment. Chaque détecteur comprend donc deux éléments détecteurs avec chacun son réseau de diffraction. Sur cette figure, on a représenté essentiellement les moyens de connexion permettant de commander de façon matricielle cette matrice de détecteurs. On voit donc sur cette figure 6 que les moyens de connexion C1 sont interconnectés par leur plot P1 vers le potentiel de commande V1. De même, les moyens de connexion C'1 sont interconnectés par leur plot de connexion P'1 au même potentiel de commande V2. La couche de contact commune à laquelle est connectée un plot P2 est connectée au potentiel de référence Vref. Enfin, dans la partie centrale de chaque détecteur est localisé un moyen de connexion Cc permettant de connecter un moyen de mesure de courant individuel pour chaque détecteur.

Sur la figure 6, on a également représenté un circuit de commande CU permettant de délivrer le potentiel de référence Vref et les potentiels de commande V1 et V2.

Un circuit de détection DET reçoit du circuit de commande CU, une information v1.2 indiquant le mode de commande délivré par le circuit CU (potentiels V1 et/ou V2). Il reçoit également les signaux de lecture délivrés par chaque pixel sur son moyen de contact commun Cc.

La figure 7 donne un tableau de commande des détecteurs ainsi réalisés. Ce tableau symbolise ainsi un moyen de commande des détecteurs. Comme on peut le voir sur cette figure 7, en mode de fonctionnement un potentiel de référence Vref est appliqué aux différents détecteurs. Lorsqu'on applique un potentiel V1 à un détecteur et qu'on n'applique pas de potentiel V2, ce détecteur permet de détecter la longueur d'onde λ₁. Inversement, si on applique un potentiel V2 mais qu'on n'applique pas un potentiel V1 à un détecteur, celui-ci détecte la longueur d'onde λ₂. Enfin, si on applique à la fois des potentiels V1 et V2 à un détecteur, il permet de détecter les longueurs d'ondes λ₁ et λ₂.

Le mode normal de fonctionnement peut être considéré comme étant le troisième mode et cela pour acquérir le maximum de signal. L'utilisation alternée dans les modes 1 et 2 permet d'ajouter une fonction de thermométrie ou de télémétrie passive. Enfin, en cas d'agression de contre-mesure optique dans une des deux fenêtres spectrales λ₁ ou λ₂, on constate que le système peut continuer à fonctionner et à acquérir le signal dans l'autre fenêtre spectrale.

On va maintenant décrire un exemple de procédé de réalisation d'un détecteur selon l'invention. Pour simplifier la description, on considérera la réalisation d'un détecteur comprenant deux éléments de détection tels que le détecteur de la figure 3 mais l'application de ce procédé pourrait concerner la réalisation d'une matrice de détecteurs.

Ce procédé comporte les étapes suivantes :
- Sur un substrat transparent (non représenté sur la figure 3), on réalise une première couche de contact ohmique 5 transparente aux longueurs d'ondes à détecter.
- Sur cette couche de contact ohmique, on réalise un empilement de puits quantiques permettant d'être photoconducteur à des gammes de longueurs d'ondes λ₁ et λ₂.
- On réalise ensuite une deuxième couche de contact ohmique transparente aux longueurs d'ondes à détecter.
- Sur cette deuxième couche de contact ohmique on réalise un deuxième empilement de puits quantiques capable d'être photoconducteur aux longueurs d'ondes à détecter.
- Sur ce deuxième empilement, on réalise deux réseaux de diffraction de caractéristiques différentes. Par exemple, ces deux réseaux permettront de diffracter la lumière vers le deuxième empilement de puits quantiques, chacun pour des longueurs d'ondes λ₁ et λ₂ différentes.
- Ensuite, par gravure on délimite la géométrie de chaque détecteur. Pour cela, on grave l'ensemble des couches jusqu'à la première couche de contact ohmique 5. On réalise également une saignée entre les deux éléments détecteurs, à la frontière des deux réseaux 3 et 3' de façon à séparer également les empilements de couches 1 et 1' des deux éléments détecteurs.
- Sur l'ensemble ainsi obtenu, on dépose une couche d'isolant 6 d'encapsulation.
- Enfin, on réalise les moyens de connexion. Pour cela, on réalise les trous suivants :
   (a) les trous traversant la couche d'isolant jusqu'aux réseaux de diffraction 3 et 3' que l'on métallise pour former les moyens de connexion C1 et C'1 ;
   (b) le trou de connexion commun traversant la couche d'isolant et le deuxième empilement jusqu'à la deuxième couche de contact ohmique pour former le moyen de connexion commun Cc permettant de le signal de lecture ;
   (c) un trou traversant la couche d'isolant et atteignant la première couche de contact ohmique 5 de façon à réaliser le moyen de connexion C2.

Il est à noter que dans ce qui précède les réseaux de diffraction 3 et 3' peuvent être métallisés pour l'application des potentiels V1 et V2.

Le procédé de l'invention a ainsi permis de réaliser le détecteur de la figure 3. Pour réaliser une matrice de détecteurs, il conviendrait de graver plusieurs détecteurs ainsi conçus sur la première couche de contact ohmique.

## Revendications

1. Détecteur optique bi-fonctionnel comportant:
- un premier élément détecteur actif à photoconducteur (1) capable de détecter une première gamme et une deuxième gamme de longueurs d'onde (λ₁ et λ₂), et auquel est associé un premier réseau de diffraction (3) permettant de coupler, dans ce premier élément détecteur, la lumière de la première gamme de longueurs d'ondes (λ₁) pour permettre au premier élément détecteur actif à photoconducteur de détecter la lumière de la première gamme de longueurs (λ₁) ;
- un deuxième élément détecteur actif à photoconducteur (1') capable de détecter une première gamme de longueurs d'onde et une deuxième gamme de longueurs d'onde (λ₁ et λ₂), et auquel est associé un deuxième réseau de diffraction (3') permettant de coupler, dans ce deuxième élément détecteur, la lumière de la deuxième gamme de longueurs d'onde (λ₂), pour permettre au deuxième élément détecteur actif à photoconducteur (1') de détecter la lumière de la deuxième gamme de longueurs d'ondes (λ₂) ;
- le premier élément détecteur est associé à un troisième élément détecteur (2) séparés par une couche de contact commune (4) ; le deuxième élément détecteur étant également associé un quatrième élément détecteur (2) séparé de celui-ci par la couche de contact (4),
- le troisième élément détecteur et le quatrième élément détecteur formant également un même détecteur ;
- les quatre éléments détecteurs étant photoconducteurs sous l'effet des mêmes gammes de longueurs d'ondes.

2. Détecteur optique selon la revendication 1, **caractérisé en ce que** les deux premiers éléments détecteurs sont réalisés dans une même couche de matériau photoconducteur.

3. Détecteur optique selon la revendication 2, **caractérisé en ce que** les deux premiers éléments détecteurs sont réalisés dans des empilements de couches formant des puits quantiques.

4. Détecteur optique selon la revendication 2, **caractérisé en ce que** les deux éléments détecteurs sont réalisés dans une alternance d'au moins deux types de puits quantiques, chaque type permettant la détection d'une longueur d'onde déterminée λ₁ ou λ₂.

5. Détecteur optique selon la revendication 4, **caractérisé en ce que** la réponse de chaque premier et deuxième détecteurs est nettement supérieure à la réponse des troisième et quatrième détecteurs de telle façon qu'ils absorbent préférentiellement l'énergie lumineuse à la gamme de longueur d'onde pour laquelle il est photoconducteur.

6. Détecteur optique selon la revendication 5, **caractérisé en ce que** les réseaux de diffraction sont en matériau conducteur ou sont revêtus par un matériau conducteur et comportent chacun un premier et un deuxième moyens de contact (C1, C'1) et **en ce que** le détecteur optique comporte également :
- un troisième moyen de contact (Cc) connecté aux faces des différents éléments détecteurs qui sont en contact avec la couche commune (4) ;
- un quatrième moyen de contact (C2) en contact avec les troisième et quatrième éléments détecteurs sur leurs faces opposées à la couche commune ;
- des moyens pour appliquer des tensions de commande (+V1, +V2, -Vref) auxdits premier, deuxième et quatrième moyens de contact (C1, C'1, C2) ;
- des moyens de mesure de conduction de courant connectés au troisième moyen de contact (Cc) pour mesurer la photoconduction desdits éléments détecteurs.

7. Détecteur optique selon la revendication 6, **caractérisé en ce qu'**il comporte des moyens de commande permettant d'appliquer une tension de référence (-Vref) au quatrième moyen de contact (C2) ainsi que :
- soit une première tension de commande (+V1) au premier moyen de contact (C1) pour commander le fonctionnement du premier et du troisième éléments détecteurs ;
- soit une deuxième tension de commande (+V2) au deuxième moyen de contact (C'1) pour commander le fonctionnement du deuxième et du quatrième éléments détecteurs ;
- soit les deux tensions (+V1 et +V2) pour commander le fonctionnement de tous les éléments détecteurs.

8. Détecteur selon la revendication 5, **caractérisé en ce qu'**il comporte une matrice d'éléments détecteurs, les quatrième moyens de contact (C2) étant communs à tous les éléments détecteurs de façon à pouvoir appliquer la tension (-Vref) à tous les détecteurs de la matrice, tous les premiers moyens de contact (C1) étant connectés entre eux de façon à appliquer sur demande la première tension de commande (V1) à tous les premiers éléments détecteurs de la matrice, tous les deuxièmes moyens de contact (C'1) étant connectés entre eux de façon à pouvoir appliquer sur demande la deuxième tension de commande (+V2) à tous les deuxièmes éléments détecteurs de la matrice.

9. Procédé de réalisation d'un détecteur optique selon l'une des revendications précédentes, **caractérisé en ce qu'**il comporte les différentes étapes suivantes :
- réalisation sur la face d'un substrat transparent d'une couche de contact ohmique (5) ;
- réalisation sur ladite couche de contact ohmique d'un empilement (2) de couches constituant un empilement de puits quantiques alternes permettant la détection d'une première gamme de longueurs d'ondes et d'une deuxième gamme de longueurs d'onde (λ₁, λ₂);
- réalisation sur cet empilement de couches d'une deuxième couche de contact ohmique (4) ;
- réalisation sur la deuxième couche de contact ohmique d'un empilement de couches constituant un empilement de puits quantiques permettant la détection d'une première gamme de longueurs d'ondes et d'une deuxième gamme de longueurs d'ondes (λ₁, λ₂);
- réalisation à la surface du deuxième empilement de couches d'au moins deux réseaux de diffraction (3 et 3') de structures physiques différentes ;
- gravure dans l'ensemble de couches obtenues et jusqu'à atteindre la première couche de contact ohmique (5), d'au moins deux éléments détecteurs, l'un des détecteurs comprenant un réseau de diffraction d'un premier type physique et l'autre élément détecteur comprenant un réseau de diffraction d'un autre type physique ;
- encapsulation de l'ensemble dans une couche d'isolant (6) ;
- gravure dans la couche d'isolant de trous traversant l'isolant et atteignant les réseaux de diffraction, et métallisation de ces trous de façon à réaliser les premier et deuxième moyens de contact (C1 et C'1) ;
- réalisation d'au moins un trou par couple d'éléments détecteurs, ledit trou atteignant la deuxième couche de contact ohmique (4) et métallisation de ce trou de façon à réaliser le troisième moyen de contact (Cc) ;
- réalisation d'un trou traversant l'isolant et atteignant la première couche de contact ohmique (5) et métallisation de ce trou de façon à réaliser le quatrième moyen de contact (C2).

## Claims

1. A bi-functional optical detector comprising:
- a first active photoconducting detector element (1) capable of detecting a first range and a second range of wavelengths (λ₁ and λ₂), which first active photoconducting detector element is associated with a first diffraction pattern (3) allowing coupling, in this first detector element, of the light from the first range of wavelengths (λ₁) to allow the first active photoconducting element to detect the light in the first range of wavelengths (λ₁);
- a second active photoconducting detector element (1') capable of detecting a first range and a second range of wavelengths (λ₁ and λ₂), which second active photoconducting detector element is associated with a second diffraction pattern (3) allowing coupling, in this second detector element, of the light from the second range of wavelengths (λ₁) to allow the second active photoconducting element to detect the light in the second range of wavelengths (λ₁);
- the first detector element is associated with a third detector element (2) separated by a common contact layer (4); said second detector element also being associated with a fourth detector element (2) separated therefrom by the contact layer (4);
- the third detector element and the fourth detector element also forming the same detector;
- the four detector elements being photoconductors under the effect of the same ranges of wavelengths.

2. The optical detector according to claim 1, **characterised in that** the two first detector elements are made from the same layer of photoconducting material.

3. The optical detector according to claim 2, **characterised in that** the two first detector elements are made from stacks of layers forming quantum wells.

4. The optical detector according to claim 2, **characterised in that** the two detector elements are made from alternating at least two types of quantum wells, each type allowing the detection of a predetermined wavelength λ₁ or λ₂.

5. The optical detector according to claim 4, **characterised in that** the response of each first and second detector is significantly greater than the response of the third and fourth detectors so that they preferably absorb the light energy at the range of wavelengths for which the detector is photoconducting.

6. The optical detector according to claim 5, **characterised in that** the diffraction patterns are made from conducting material or are coated with a conducting material and each include a first and a second contact means (C1, C'1) and **in that** the optical detector further comprises:
- a third contact means (Cc) connected to the surfaces of the different detector elements which are in contact with the common layer (4);
- a fourth contact means (C2) in contact with the third and fourth detector elements on their surfaces which are opposite the common layer;
- means for applying control voltages (+V1, +V2, -Vref) of said first, second and fourth contact means (C1, C'1, C2);
- means for measuring the conduction of the current connected to the third contact means (Cc) in order to measure the photoconduction of said detector elements.

7. The optical detector according to claim 6, **characterised in that** it includes control means which allow the application of a reference voltage (-Vref) to the fourth contact means (C2) as well as:
- either a first control voltage (+V1) to the first contact means (C1) to control the operation of the first and the third detector elements;
- or a second control voltage (+V2) to the second contact means (C'1) to control the operation of the second and the fourth detector elements;
- or both voltages (+V1 and +V2) to control the operation of all of the detector elements.

8. The optical detector according to claim 5, **characterised in that** it includes a matrix of detector elements, the fourth contact means (C2) being common to all of the detector elements so that the voltage (-Vref) may be applied to all of the detectors in the matrix, all of the first contact means (C1) being connected together so as to apply on request the first control voltage (V1) to all of the first detector elements of the matrix, all of the second contact means (C'1) being connected together so as to be able to apply on request the second control voltage (+V2) to all of the second detector elements of the matrix.

9. A process for manufacturing an optical detector according to any one of the previous claims, **characterised in that** it includes the following different steps:
- producing an Ohmic contact layer (5) on the surface of a transparent substrate;
- producing, on said Ohmic contact layer, a stack (2) of layers constituting a stack of alternating quantum wells which allow the detection of a first range of wavelengths and a second range of wavelengths (λ₁, λ₂);
- producing a second Ohmic contact layer (4) on this stack of layers;
- producing a stack of layers on the second Ohmic contact layer, which stack constitutes a stack of quantum wells which allow the detection of a first range of wavelengths and a second range of wavelengths (λ₁, λ₂);
- producing at least two diffraction patterns (3 and 3') with different physical structures on the surface of the second stack of layers;
- etching, in the resulting set of layers and up to the first Ohmic contact layer (5), at least two detector elements, one of which includes a diffraction pattern of a first physical type and the other comprising a diffraction pattern of another physical type;
- encapsulating the assembly within an insulating layer (6);
- etching holes in the insulating layer, which holes pass through the insulation and reach the diffraction pattern, and metallising these holes so as to produce the first and second contact means (C1 and C'1).
- producing at least one hole per pair of detector elements, said hole reaching the second Ohmic contact layer (4) and metallising this hole so as to produce the third contact means (Cc);
- producing a hole passing through the insulation and reaching the first Ohmic contact layer (5) and metallising this hole so as to produce the fourth contact means (C2).

## Patentansprüche

1. Bifunktioneller optischer Detektor, der Folgendes umfasst:
- ein erstes aktives photoleitendes Detektorelement (1) zum Erfassen eines ersten Bereichs und eines zweiten Bereichs von Wellenlängen (λ₁ und λ₂), das mit einem ersten Beugungsgitter (3) assoziiert ist, das ein Koppeln, in diesem ersten Detektorelement, des Lichts aus dem ersten Wellenlängenbereich (λ₁) zulässt, damit das erste aktive lichtleitende Element das Licht in dem ersten Wellenlängenbereich (λ₁) erfassen kann;
- ein zweites aktives photoleitendes Detektorelement (1') zum Erfassen eines ersten Bereichs und eines zweiten Bereichs von Wellenlängen (λ₁ und λ₂), das mit einem zweiten Beugungsgitter (3) assoziiert ist, das ein Koppeln, in diesem zweiten Detektorelement, des Lichts aus dem zweiten Wellenlängenbereich (λ₁) zulässt, damit das zweite aktive lichtleitende Element das Licht in dem zweiten Wellenlängenbereich (λ₂) erfassen kann;
- wobei das erste Detektorelement mit einem dritten Detektorelement (2) assoziiert ist, getrennt durch eine gemeinsame Kontaktschicht (4); wobei das zweite Detektorelement auch mit einem vierten Detektorelement (2) assoziiert ist, durch die Kontaktschicht (4) davon getrennt;
- wobei das dritte und das vierte Detektorelement auch denselben Detektor bilden;
- wobei die vier Detektorelemente Photoleiter unter dem Effekt derselben Wellenlängenbereiche sind.

2. Optischer Detektor nach Anspruch 1, **dadurch gekennzeichnet, dass** die beiden ersten Detektorelemente aus derselben Schicht aus lichtleitendem Material hergestellt sind.

3. Optischer Detektor nach Anspruch 2, **dadurch gekennzeichnet, dass** die beiden ersten Detektorelemente aus Stapeln von Quantumtöpfen bildenden Schichten hergestellt sind.

4. Optischer Detektor nach Anspruch 2, **dadurch gekennzeichnet, dass** die beiden Detektorelemente durch abwechselnde wenigstens zwei Typen von Quantumtöpfen gebildet sind, wobei jeder Typ die Erfassung einer vorbestimmten Wellenlänge λ₁ oder λ₂ zulässt.

5. Optischer Detektor nach Anspruch 4, **dadurch gekennzeichnet, dass** die Reaktion jedes ersten und zweiten Detektors erheblich stärker ist als die Reaktion des dritten und vierten Detektors, so dass sie vorzugsweise die Lichtenergie in dem Wellenlängenbereich absorbieren, für den der Detektor fotoleitend ist.

6. Optischer Detektor nach Anspruch 5, **dadurch gekennzeichnet, dass** die Beugungsgitter aus leitendem Material gefertigt oder mit einem leitenden Material beschichtet sind und jeweils ein erstes und ein zweites Kontaktmittel (C1, C'1) aufweisen, und **dadurch**, dass der optische Detektor ferner Folgendes umfasst:
- ein drittes Kontaktmittel (Cc), das mit den Oberflächen der verschiedenen Detektorelemente verbunden ist, die mit der gemeinsamen Schicht (4) in Kontakt sind;
- ein viertes Kontaktmittel (C2) in Kontakt mit dem dritten und vierten Detektorelement auf deren Oberflächen, die der gemeinsamen Schicht gegenüber liegen;
- Mittel zum Anlegen von Steuerspannungen (+V1, +V2, -Vref) des ersten, zweiten und vierten Kontaktmittels (C1, C'1, C2);
- Mittel zum Messen der Leitung des mit dem dritten Kontaktmittel (Cc) verbundenen Stroms, um die Photoleitung der Detektormittel zu messen.

7. Optischer Detektor nach Anspruch 6, **dadurch gekennzeichnet, dass** er Steuermittel aufweist, die ein Anlegen einer Referenzspannung (-Vref) an das vierte Kontaktmittel (C2) zulassen, sowie:
- entweder einer ersten Steuerspannung (+V1) an das erste Kontaktmittel (C1) zum Steuern des Betriebs des ersten und dritten Detektorelements;
- oder einer zweiten Steuerspannung (+V2) an das zweite Kontaktmittel (C'1) zum Steuern des Betriebs des zweiten und vierten Detektorelements;
- oder beider Spannungen (+V und +V2) zum Steuern des Betriebs aller Detektorelemente.

8. Optischer Detektor nach Anspruch 5, **dadurch gekennzeichnet, dass** er eine Matrix von Detektorelementen aufweist, wobei das vierte Kontaktmittel (C2) allen Detektorelementen gemeinsam ist, so dass die Spannung (-Vref) an alle Detektoren in der Matrix angelegt werden kann, wobei alle ersten Kontaktmittel (C1) zusammengeschaltet sind, um auf Anforderung die erste Steuerspannung (V1) an alle ersten Detektorelemente der Matrix anzulegen, wobei alle zweiten Kontaktmittel (C'1) zusammengeschaltet sind, damit auf Anforderung die zweite Steuerspannung (+V2) an alle zweiten Detektorelemente der Matrix angelegt werden kann.

9. Verfahren zur Herstellung eines optischen Detektors nach einem der vorherigen Ansprüche, **dadurch gekennzeichnet, dass** es die folgenden unterschiedlichen Schritte beinhaltet.
- Erzeugen einer ohmschen Kontaktschicht (5) auf der Oberfläche eines transparenten Substrats;
- Erzeugen, auf der ohmschen Kontaktschicht, eines Stapels (2) von Schichten, die einen Stapel von abwechselnden Quantumtöpfen bilden, die die Erkennung eines ersten Wellenlängenbereichs und eines zweiten Wellenlängenbereichs (λ₁, λ₂) zulassen;
- Erzeugen einer zweiten ohmschen Kontaktschicht (4) auf diesem Stapel von Schichten;
- Erzeugen eines Stapels von Schichten auf der zweiten ohmschen Kontaktschicht, der einen Stapel von Quantumtöpfen bildet, die die Erfassung eines ersten Wellenlängenbereichs und eines zweiten Wellenlängenbereichs (λ₁, λ₂) zulassen;
- Erzeugen von wenigstens zwei Beugungsgittern (3 und 3') mit unterschiedlichen physikalischen Strukturen auf der Oberfläche des zweiten Stapels von Schichten;
- Ätzen, im erhaltenen Satz Schichten und bis zur ersten ohmschen Kontaktschicht (5), von wenigstens zwei Detektorelementen, von denen eines ein Beugungsgitter eines ersten physikalischen Typs aufweist und das andere ein Beugungsgitter eines anderen physikalischen Typs aufweist;
- Verkapseln der Baugruppe in einer Isolierschicht (6);
- Ätzen von Löchern in der Isolierschicht, die durch die Isolierung verlaufen und das Beugungsgitter erreichen, und Metallisieren dieser Löcher, um die ersten und zweiten Kontaktmittel (C1 und C'1) zu erzeugen;
- Erzeugen von wenigstens einem Loch pro Detektorelementepaar, das die zweite ohmsche Kontaktschicht (4) erreicht, und Metallisieren dieses Lochs, um das dritte Kontaktmittel (Cc) zu erzeugen;
- Erzeugen eines Lochs, das durch die Isolierung geht und die erste ohmsche Kontaktschicht (5) erreicht, und Metallisieren dieses Lochs, um das vierte Kontaktmittel (C2) zu erzeugen.
